# EUROPEAN PATENT SPECIFICATION

(11) **EP 3 478 634 B1**
(45) Date of publication and mention of the grant of the patent: **27.10.2021**
(21) Application number: 17761570.5
(22) Date of filing: 30.06.2017
(51) Int. Cl.: C01B 32/184, C01B 32/188, C30B 29/02, C30B 33/02, B82Y 30/00, B82Y 40/00

(54) **METHOD FOR PREPARATION OF HIGH-QUALITY GRAPHENE ON THE SURFACE OF SILICON CARBIDE**
VERFAHREN ZUR HERSTELLUNG VON HOCHWERTIGEM GRAPHEN AUF DER OBERFLÄCHE VON SILICIUMCARBID
PROCÉDÉ DE PRÉPARATION DE GRAPHÈNE DE HAUTE QUALITÉ À LA SURFACE DE CARBURE DE SILICIUM

(30) Priority: 02.07.2016 PL 41780416
(43) Date of publication of application: 08.05.2019
(73) Proprietor: Uniwersytet Jagiellonski, 31-007 Krakow (PL)
(72) Inventor: CIOCHON, Piotr, 30-376 Krakow (PL); KOLODZIEJ, Jacek, 30-412 Krakow (PL)
(74) Representative: AOMB Polska Sp. z.o.o.
(86) International application number: PCT/IB2017/053969
(87) International publication number: WO 2018/007918

(56) References cited:
- US-A1- 2011 223 094
- LUXMI ET AL: "Comparison of graphene formation on C-face and Si-face SiC {0001} surfaces", PHYSICAL REVIEW. B, CONDENSED MATTER AND MATERIALS PHYSICS, vol. 82, no. 23, 1 December 2010 (2010-12-01), page 235406, XP055413224, US ISSN: 1098-0121, DOI: 10.1103/PhysRevB.82.235406
- Yu Cui, Li Jia, Liu Qing-Bin, Cai Shu-Jun, Feng Zhi-Hong: "Quasi-equilibrium growth of monolayer epitaxialgraphene on SiC (0001)", Acta Physica Sinica, 1 January 2014 (2014-01-01), XP055413275, DOI: 10.7498/aps.63.038102 Retrieved from the Internet: URL:http://wulixb.iphy.ac.cn/EN/article/do wnloadArticleFile.do?attachType=PDF&id=579 45 [retrieved on 2017-10-06]
- R. M. TROMP ET AL: "Thermodynamics and Kinetics of Graphene Growth on SiC(0001)", PHYSICAL REVIEW LETTERS, vol. 102, no. 10, 1 March 2009 (2009-03-01), XP055413228, US ISSN: 0031-9007, DOI: 10.1103/PhysRevLett.102.106104
- PIOTR CIOCHON ET AL: "Graphitization of SiC (0001) Surface in the Si Flux", PROCEEDINGS OF THE 2ND WORLD CONGRESS ON NEW TECHNOLOGIES, 1 July 2016 (2016-07-01), XP055413200, ISSN: 2369-8128, DOI: 10.11159/icnfa16.151 ISBN: 978-1-927877-26-5

## Description

The invention relates to an improved method for preparation of high-quality graphene on the surface (0001) of silicon carbide by superficial graphitisation of the compound in a stream of silicon atoms from an external sublimation source.

Due to its unique properties, such as: a very high mobility of charge carriers (up to 200 000 cm²V⁻¹s⁻¹, while compared with 1400 cm²V⁻¹s⁻¹ for silicon; a high saturation velocity of charge carriers (approx. 5×10⁷ cm s⁻¹); a very high thermal conduction (up to 5000 W/mK) ; mechanical strength; or almost ballistic character of electric conduction at room temperature, graphene is one of the most important materials to be applied in future electronics, based on materials other than silicon.

Synthesis of high-quality graphene with large sizes of single crystalline domains still poses a big challenge. The synthesis methods currently used, such as chemical vapour deposition, mechanical exfoliation of graphite, superficial ordering of carbon atoms dissolved in a volume of metals, or synthesis by chemical reactions, very often lead to formation of a material having significantly worse characteristics than the ones theoretically predicted. Additionally, the necessity to transfer the graphene onto an insulating substrate in order to use it in electronics is problematic.

One of the most promising methods of graphene synthesis directly on the insulating substrate is the superficial graphitisation of silicon carbide surface with (0001) crystallographic orientation, observed for the first time already in 1961.

At a temperature of 1100-1200ºC, under an ultra-high vacuum (UHV), the superficial SiC layers undergo thermal decomposition. More volatile silicon atoms are desorbed, and the excessive carbon atoms remaining on the surface undergo a reorganisation and form graphene layers .

Formation of graphene starts on the first superficial layer of the SiC substrate at the step edges, and advances on the surface and deeper into the material.

To form a monolayer, on average, three layers of silicon carbide should be decomposed. Under the formed monolayer, a so-called buffer layer forms, in which the carbon atoms are ordered similarly as in the higher graphene layer, but they still form covalent bonds with silicon atoms inside the SiC. This layer is a reconstructed surface of silicon carbide and is non-conducting. It is also responsible for the n-type doping of the overlying graphene.

After the formation of the first monolayer, further growth of graphene is limited by its defects.

Summarising, under ultra-high vacuum conditions, the graphitisation occurs at relatively low temperatures, at which carbon atoms have a very low mobility and form a highly defected graphene layer with a variable thickness of 1 to approx. 6 monolayers.

Patent Application No. US 20140175458 A1 describes a method for graphene synthesis on the surface of silicon carbide, consisting of depositing a metallic layer onto the surface of silicon carbide connected with double annealing at temperatures T1=810-900ºC and T2=1010-1100ºC. This method results in formation of graphene on a layer of a metal-silicon carbide composite separating the graphene from the substrate (pure SiC surface).

Patent No. US 9150417 B2 discloses an invention relating to an improvement of the quality of graphene obtained by superficial graphitisation of silicon carbide. It consists in carrying out the graphitisation in a buffer gas atmosphere (e.g. argon), under a pressure of approx. 6×10⁴ Pa. Under these conditions, the sublimation rate of silicon atoms is significantly reduced, because after desorption, they have a finite probability of return onto the surface in the result of collisions with argon atoms; alternatively, it may be understood in thermodynamic terms as a slowdown of the evaporation process after increasing enthalpy of this transition by a pressure-volume factor. Due to this fact, the graphitisation process occurs at significantly higher temperatures, of the order of 1450-1500ºC. In this temperature range, carbon atoms have higher mobility and form graphene layers characterized by higher quality and a relatively uniform thickness of approx. 1-2 monolayers.

In this process, the graphene quality strongly depends on the quality of the substrate's surface.

One should note that the buffer gases used in the process being described may be characterised by a purity of at most 6N (10⁻⁶ impurities). Under a gas pressure in the reaction chamber of approx. 100 kPa, the partial pressure of the dopants amounts to approx. 10⁻¹ Pa, corresponding to an exposure of the surface to a stream of unknown particles of impurities having a gigantic volume of the order of 1000 L/s (1000 layers of impurities per second).

Patent Application No. US 20110223094 A1 describes an invention consisting in graphene synthesis on the surface of silicon carbide by placing two crystals: silicon and silicon carbide, in parallel, in some distance, in a vacuum chamber, then pumping off the air from the vacuum chamber to a pressure of the order of 1×10⁻⁴ Pa, annealing the silicon crystal to a temperature of approx. 1200ºC with a simultaneous annealing of the silicon carbide crystal to temperatures of 1500ºC, 1600ºC and 1700ºC.

The publication by Luxmi et al, "Comparison of graphene formation on C-face and Si-face SiC {0001} surfaces", Physical Review. B, Condensed Matter And Materials Physics, Us, (20101201), discloses a method for preparation of graphene on the surface of silicon carbide. However, this document does not disclose that the annealing is done in a stream of silicon atoms from an external sublimation source.

The publication by Yu Cui, Li Jia, Liu Qing-Bin, Cai Shu-Jun, Feng Zhi-Hong, "Quasi-equilibrium growth of monolayer epitaxial graphene on SiC (0001)", Acta Physica Sinica, describes a method for production of quality graphene on Sic in the presence of silicon vapour, resulting in improved graphene monolayer growth. However, the method employs silicon vapour in a stream of argon and not as a stream of silicon atoms.

The goal of the invention is to provide high-quality graphene with a low level of impurities and a basically defectless structure of the graphene crystalline lattice, i.e. a honeycomb structure, as well as a method for obtaining such high-quality graphene.

It was surprisingly found that the increase in silicon partial pressure in the direct vicinity of the surface of silicon carbide subjected to graphitisation, achieved in accordance with the invention, advantageously slows down the process of sublimation of silicon atoms, leading to synthesis of a better ordered higher-quality graphene.

The invention relates to a method for preparation of graphene on the surface of silicon carbide, characterised in that an SiC crystal with a crystallographic orientation of the surface (0001), is subjected to, consecutively:
a) a pressure below 1×10⁻⁷ Pa;
b) annealing at a temperature from 1300ºC do 1800ºC, under a pressure not higher than 5×10⁻⁵ Pa, in a stream of silicon atoms from an external sublimation source corresponding to a nominal silicon growth rate from 0.5×10⁻¹⁰ m/min to 10×10⁻¹⁰ m/min.

Preferably, the SiC crystal is subjected to a step of degassing by annealing at a temperature from 100°C to 850°C under a pressure not higher than 1×10⁻⁷ Pa, performed between the steps a) and b).

Preferably, the SiC crystal is subjected to annealing at a temperature from 900°C to 1050°C in a stream of silicon atoms from an external sublimation source corresponding to a nominal silicon growth rate from 0.5×10⁻¹⁰ m/min to 2.5×10⁻¹⁰ m/min, performed between the steps a) and b).

Preferably, the SiC crystal is subjected to annealing at a temperature from 900°C to 1050°C in a stream of silicon atoms from an external sublimation source corresponding to a nominal silicon growth rate from 0.5×10⁻¹⁰ m/min to 2.5×10⁻¹⁰ m/min, performed between the step of degassing and the step b).

The layer of graphene obtained by the method of the invention is basically devoid of crystal defects, and it may comprise from one to four, particularly from one to two, atomic layers forming a crystal lattice with a honeycomb structure, its diffraction spectrum obtained by low-energy electron diffraction having a diffraction pattern typical for the graphene on the SiC surface (0001), and the ratio of the maximum signal intensity to the minimum signal intensity (SNR), measured at room temperature, in the section between the two consecutive diffraction maxima connected with graphene is higher than 9.

Preferably, said graphene has SNR value higher than 9.8 for the annealing temperature higher than 1501ºC in step d). Preferably, the SNR value is higher than 11 for the annealing temperature lower than 1501ºC in step d). Particularly preferably, the SNR value is higher than 13 for the annealing temperature lower than 1501ºC in step d), the preparation method including step b) of the method according to the invention defined above. Particularly preferably, the SNR value is higher than 17 for the annealing temperature lower than 1501ºC in step d), the preparation method including steps b) and c) of the method according to the invention defined above.

The method for preparation of graphene according to the invention is based on a replacement of buffer gases during graphitisation with a stream of silicon atoms originating from an external sublimation source of a high purity, to slow down the superficial sublimation of silicon atoms from the surface of silicon carbide.

Due to the application of an external sublimation source, the exposure of the surface to impurities was reduced significantly. For a beam equivalent pressure (BEP) of approx. 10⁻² Pa, the BEP value for the impurities will amount to approx. 10⁻⁵ Pa at worst, i.e. even 4 orders of magnitude less than in case of application of buffer gases. Additionally, while using an external sublimation source, the density of the silicon atoms stream may be set basically to any value and thus the graphitisation temperature may be increased significantly.

In order for the graphene formed on the surface of silicon carbide to be characterised by desired properties, its perfect crystallographic ordering is necessary (the atoms must form a lattice with a honeycomb structure with a low concentration of defects, such as vacancies, dislocations or intergranular boundaries), high purity (a low concentration of impurities), and in consequence - an electron structure corresponding to theoretical predictions (a linear relation of electron dispersion near the K point of the reciprocal lattice), connected with a lack of incoherent dispersions.

In the method according to the invention, the density of the silicon atoms stream was defined so as to achieve almost equilibrium conditions of the process. Under such conditions, loss of silicon from the surface occurs very slow. Due to this fact, while using sufficiently high temperatures, the superficial carbon atoms have a sufficient thermal energy and time for the superficial system to be reorganised to an almost model graphene/SiC state.

Surprisingly, it was found that the method according to the invention leads to obtaining a very high-quality graphene devoid of crystalline defects directly on the insulating substrate of silicon carbide. An additional adjustments of the annealing time value and the stream of silicon atoms from an external sublimation source allow for obtaining synthesis of a single layer up to four atomic layers of graphene.

### Method for determination of quality of the obtained graphene

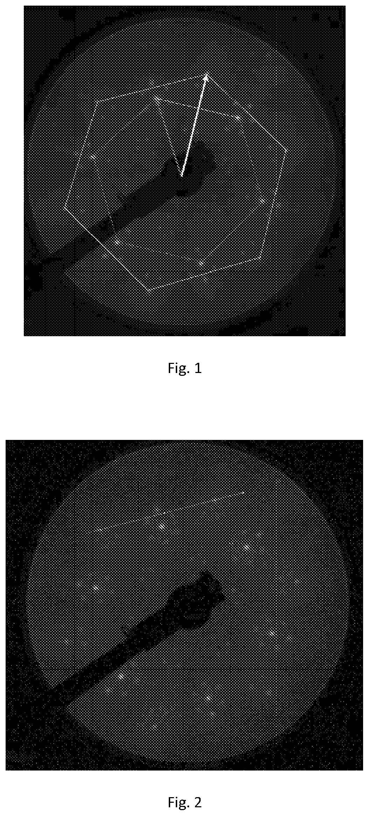

Low energy electron diffraction (LEED) was used for evaluation of quality of the prepared graphene. A suitable diffraction pattern, shown in Fig. 1 (an image for electron energy of 156 eV), constitutes a parameter indicating the presence on the surface of graphene. In accordance with the invention, it is a diffraction pattern typical for the graphene on the SiC surface (0001).

The gray vector is a vector connected with the substrate's surface (silicon carbide), while the white vector is a vector connected with the graphene being synthesised. Diffraction maxima connected with silicon carbide are located in the corners of the gray hexagon, while the maxima connected with graphene are located in the corners of the white hexagon. The most intense diffraction maxima originating from silicon carbide are surrounded by six maxima of a lower intensity (the hexagon around the most bright peaks), while the most intense diffraction maxima originating from graphene are surrounded by two strongest maxima located towards the centre of the diffraction image (the maximum connected with graphene and two secondary maxima form a triangle). Additional maxima, also forming a hexagon but not always visible, may be located around the maximum connected with graphene.

A parameter which allows for evaluating the quality and the crystallographic order is constituted by a ratio of intensities of the diffraction maxima to the background level. In order to evaluate this quantity numerically in accordance with the invention, a signal analysis should be carried out between the two consecutive diffraction maxima connected with graphene, as shown for example in Fig. 2.

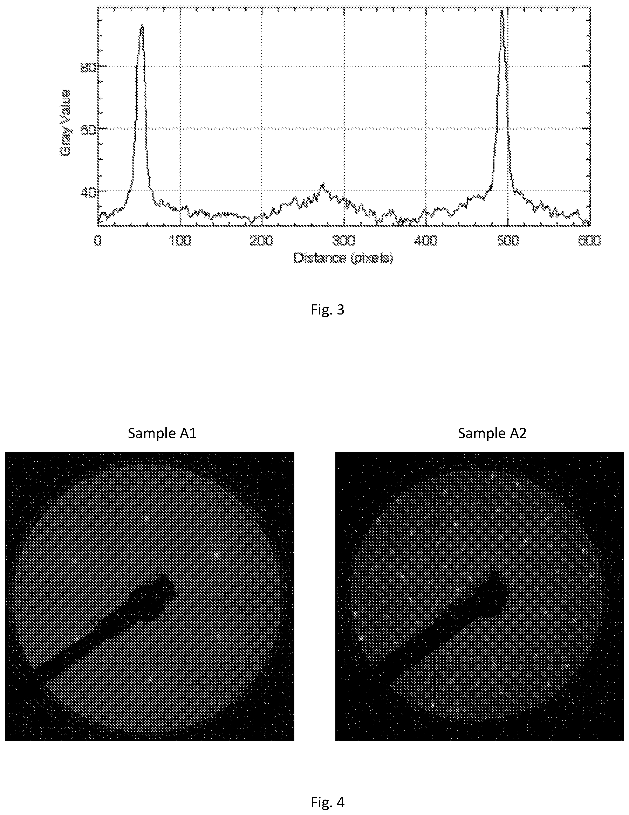

The signal intensity profile along this line is shown in Fig. 3.

The SNR (signal to noise ratio) value is obtained by dividing the maximum signal intensity in the defined profile by the minimum intensity. In the example shown, the SNR value amounts to: SNR=90/30=3.

By subjecting the diffraction patterns of the consecutive samples to a similar analysis, a quality evaluation of the graphene surface is carried out.

A. Preliminary preparation of the SiC surface.

To obtain favourable results, it is desired to prepare the starting surface of silicon carbide (which is subjected to the graphitisation process thereafter) by annealing under ultra-high vacuum at temperatures from 100ºC to 850ºC, and annealing under a vacuum higher then 5×10⁻⁵ Pa at a temperature from 900ºC to 1050ºC, combined with directing a stream of silicon atoms onto the sample, resulting in a nominal silicon growth rate of 0.5-2.5×10⁻¹⁰ m/min.

The starting surface should be cooled to room temperature and its quality should be checked by diffraction methods (LEED). After the preparation, the surface is characterised by a (3×3) surface reconstruction, which is shown in the examples (A) below.

### Example A1.

The method for preparation of sample 1: introduction to the vacuum chamber, pumping off the chamber to a pressure <1×10⁻⁷ Pa, annealing of the sample at a temperature increased gradually from 100 to 850ºC (degassing), annealing of the sample at a temperature 950ºC under vacuum (without the stream of silicon atoms) for a time t=10 minutes.

### Example A2.

The method for preparation of sample 2: introduction to the vacuum chamber, pumping off the chamber to a pressure <1×10⁻⁷ Pa, annealing of the sample at a temperature increased gradually from 100 to 850ºC (degassing), annealing of the sample at a temperature 950ºC in a stream of silicon atoms resulting in a nominal silicon growth rate of 0.5-2.5×10⁻¹⁰ m/min for a time t=10min.

Then, tests of the obtained surface were carried out. The results are presented in Fig. 4.

The tests were carried out by low energy electron diffraction using two samples prepared according to examples A1 and A2. The results in the form of diffraction patterns for electron energy equal to 142 eV are shown in Fig. 4.

The starting surface prepared by annealing in a stream of silicon atoms is characterised by a surface reconstruction of (3×3) type. Also, this surface is characterised by an almost perfect crystallographic ordering, which is proved by a very high number of observable diffraction maxima, their small transverse size, their high brightness and a low brightness of the background (a high ratio of the signal intensity to the background intensity, which proves a low number of crystallographic defects and amorphous areas of the surface). The surface prepared under vacuum is characterised by a reconstruction of (1×1) type and a low degree of crystallographic ordering, which is proved by a very high intensity of the background, a relatively low intensity of the diffraction maxima and a diffused transverse shape of the maxima.

B. Graphitisation of pre-prepared SiC surface.

The starting surface prepared in a way described above was subjected to the graphitisation process at temperatures from 1300 to 1800ºC in a stream of silicon atoms from an external sublimation source, corresponding to a nominal growth rate of silicon layers of 0.5-10×10⁻¹⁰ m/min. under a pressure in the vacuum chamber not exceeding 5×10⁻⁵ Pa. After the preparation, high-quality graphene (described in detail above) forms on the surface, which is shown in the examples (B) below:

### Example B1.

The method for preparation of sample 1: introduction to the vacuum chamber, pumping off the chamber to a pressure <1×10⁻⁷ Pa, annealing of the sample at a temperature increased gradually from 100 to 850ºC (degassing - no preparation of the starting surface (3×3)), annealing of the sample at a temperature 1450ºC (without the stream of silicon atoms) for a time t=10 minutes.

### Example B2.

The method for preparation of sample 2: introduction to the vacuum chamber, pumping off the chamber to a pressure <1×10⁻⁷ Pa, annealing of the sample at a temperature increased gradually from 100 to 850ºC (degassing - no preparation of the starting surface (3×3)), annealing of the sample at a temperature 1450ºC in a stream of silicon atoms resulting in a nominal silicon growth rate of approx. 4×10⁻¹⁰ m/min for a time t=10 minutes.

### Example B3.

The method for preparation of sample 3: after preparation of the starting surface characterised by a (3×3) surface reconstruction, as described above: annealing of the sample at a temperature 1450ºC (without the stream of silicon atoms) for a time t=10 minutes.

### Example B4.

The method for preparation of sample 4: after preparation of the starting surface characterised by a (3×3) surface reconstruction, as described above: annealing of the sample at a temperature 1450ºC in a stream of silicon atoms resulting in a nominal silicon growth rate of approx. 4×10⁻¹⁰ m/min for a time t=10 minutes.

### Diffraction studies of the obtained samples

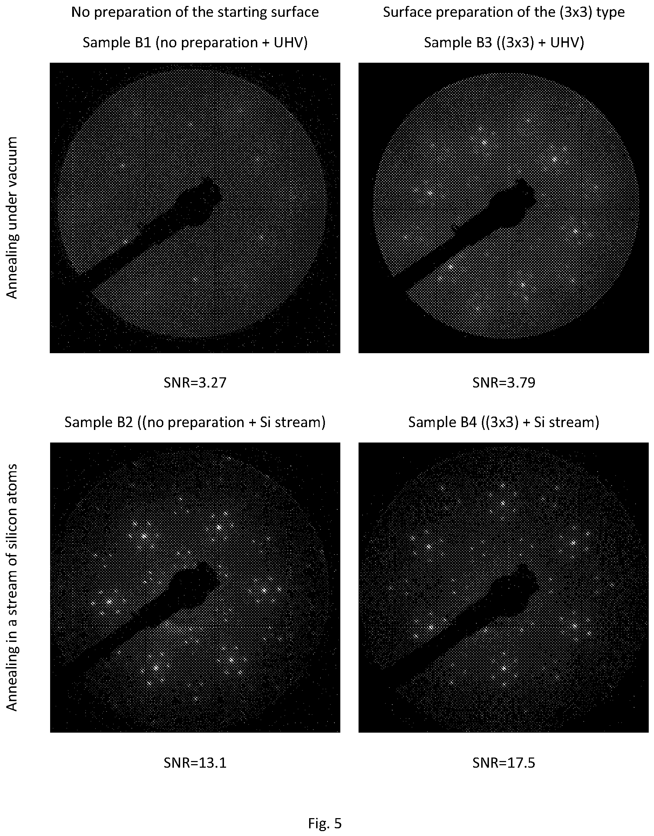

The tests were carried out by low energy electron diffraction at room temperature using two samples prepared according to schemes B1-B4. The results in the form of diffraction patterns for electron energy equal to 156 eV are shown in Fig. 5.

It was found that the surface prepared by preparation of the starting surface of (3×3) type and annealing in a stream of silicon atoms is characterised by a distinctly better crystallographic ordering. The diffraction maxima are well-formed, have perfect shapes and high intensities, while the background is practically invisible. This is an evidence of a high ordering degree and a minimum concentration of all defects in the graphene layer and amorphous areas on the surface of sample.

### Spectroscopic studies of the obtained samples

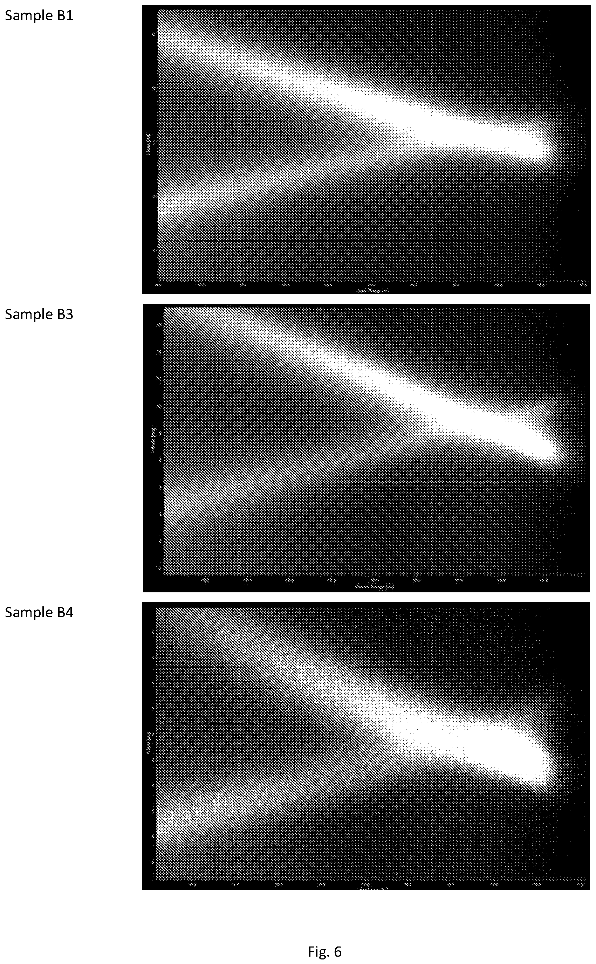

The tests were carried out by angle-resolved photoemission spectroscopy in the UV-radiation range (UV-ARPES) at room temperature using two samples prepared according to schemes B1, B3 and B4. The results in the form of spectra presenting the intensity distribution of photoelectrons sputtered by the UV radiation *vs*. the emission angle (vertical axis) and kinetic energy (horizontal axis), which allows for imaging of electronic structures of materials, are shown in Fig. 6.

The spectra presented in Fig. 6 show the electron distribution in graphene in the vicinity of point K. As predicted theoretically, the dispersion relation (dependence of energy on electron quasi-momentum, linearly proportional to the emission angle of the electron from the sample - vertical axis) should be linear around this point, which is evident for all samples, thus graphene has been formed on the surface of all samples.

A parameter which allows for determining the impact of the surface ordering on the photoemission spectra is constituted by the background intensity. The lowest background intensity (formally the ratio of the signal intensity to the background intensity) was observed for sample B4 (the signal intensity between two branches of the linear dispersion relation is noteworthy).

High-quality graphene may be obtained by the method according to the invention for relatively broad range of values of the critical parameters, particularly the graphitisation temperature and the stream of silicon atoms. It was illustrated in the preferred embodiments described below, which should not be however identified with the full scope of the invention being claimed.

### Example 1.

The method for preparation of sample 1: after preparation of the starting surface characterised by a (3x3) surface reconstruction, as described above: annealing of the sample at a temperature 1500ºC in a stream of silicon atoms resulting in a nominal silicon growth rate of approx. 1×10⁻¹⁰ m/min for a time t=10 minutes.

### Example 2.

The method for preparation of sample 2: after preparation of the starting surface characterised by a (3×3) surface reconstruction, as described above: annealing of the sample at a temperature 1500-̊C in a stream of silicon atoms resulting in a nominal silicon growth rate of approx. 25×10⁻¹⁰ m/min for a time t=10 minutes.

### Example 3.

The method for preparation of sample 3: after preparation of the starting surface characterised by a (3×3) surface reconstruction, as described above: annealing of the sample at a temperature 1200ºC in a stream of silicon atoms resulting in a nominal silicon growth rate of approx. 1×10⁻¹⁰ m/min for a time t=10 minutes.

### Example 4.

The method for preparation of sample 4: after preparation of the starting surface characterised by a (3×3) surface reconstruction, as described above: annealing of the sample at a temperature 1700ºC in a stream of silicon atoms resulting in a nominal silicon growth rate of approx. 4×10⁻¹⁰ m/min for a time t=6 minutes.

The quality and structure of the graphene samples obtained in Examples 1-4 were analysed.

### Tests 1

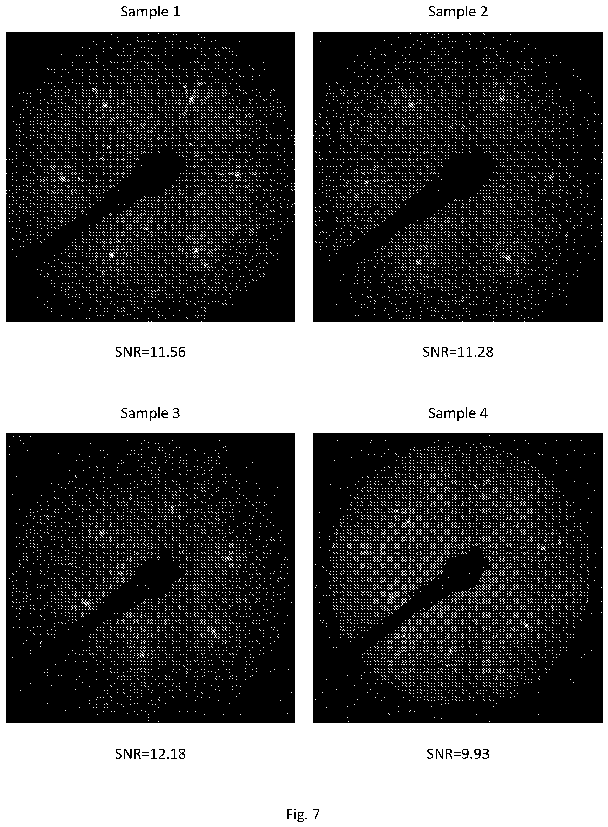

The quality and structure of the graphene samples obtained in accordance with Examples 1-4 (samples 1-4, respectively) were tested by low energy electron diffraction at room temperature. The results in the form of diffraction patterns for electron energy equal to 156 eV are shown in Fig. 7.

### Tests 2

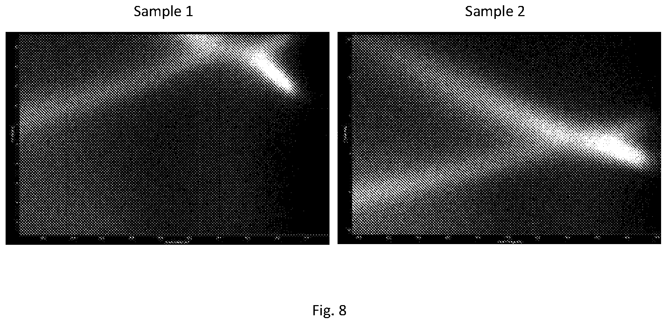

The quality and structure of the graphene samples obtained in accordance with Examples 1-2 (samples 1 and 2, respectively) were tested by angle-resolved photoemission spectroscopy at room temperature. The results in the form of diffraction patterns for electron energy equal to 156 eV are shown in Fig. 8.

In each of the embodiments, high quality graphene was formed on the surface of the sample, which was confirmed by diffraction and spectroscopic tests. The exact structure of the surface varies, but all of them are characterised by a very high crystallographic ordering and electron structures of high quality.

### Tests 3

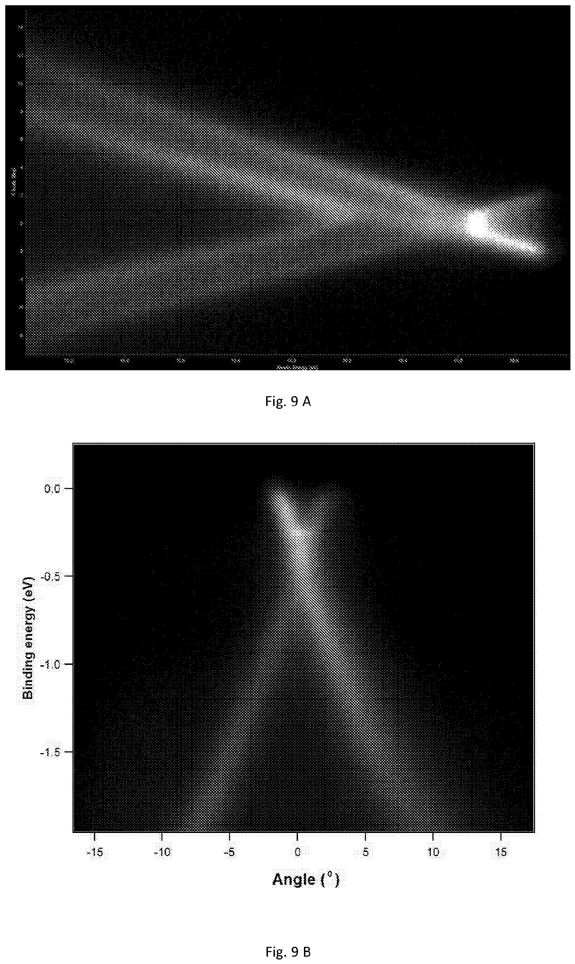

The graphene sample obtained in Example 4 was analysed by angle-resolved photoemission spectroscopy at liquid nitrogen temperature (T=78 K). The results in the form of an ARPES spectrum are shown in Fig. 9A and B.

The sample 4 is characterised by a very high quality of the surface, which is evidenced by sharp bands in the dispersion relation and a very low background level. Additionally, two graphene layers occur on the sample, which is evident in the ARPES spectrum as a splitting of linear branches of the dispersion relation. This fact confirms that the method according to the invention allows for controlling the number of the graphene layers formed on the surface.

### Tests 4

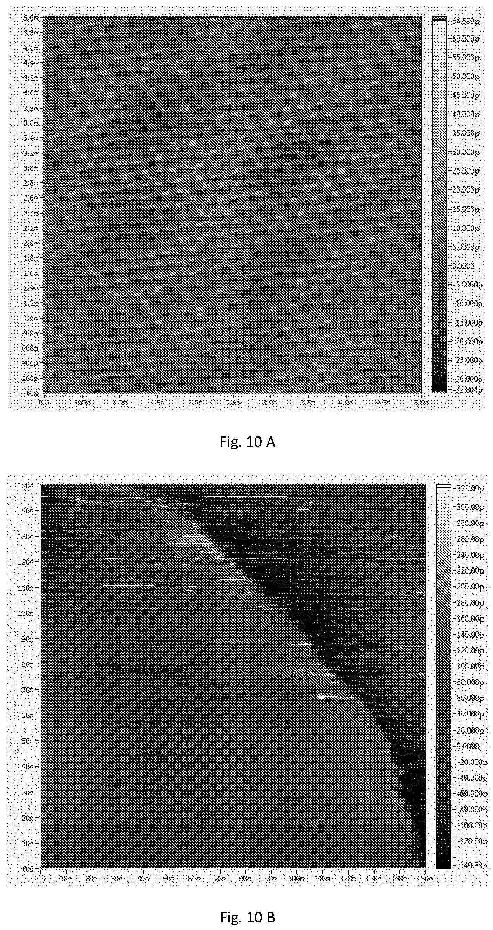

The graphene sample obtained in Example 4 was analysed by scanning tunnelling microscopy at room temperature under vacuum (an Omicron RT-STM/AFM microscope, the microscope tip made of etched tungsten, polarisation voltage of 15 mV, tunnelling current of 100 pA). The results in the form of a microscopic image are shown in Fig. 10A and B

In the microscopic image, the perfect crystallographic structure of graphene is evident: the honeycomb structure. The unit cell of graphene is a single small hexagon; the change in the background intensity results from the effect of the subsurface layer (a buffer layer with a (6√3×6√3)R30º symmetry). The structure is characterised by a very low amount of any impurities or defects, confirming the high quality and crystallographic ordering on the surface of sample.

### Summary

The presented method for graphene synthesis take advantage of the physical phenomena described in the Patent Application No. US 20110223094 A1. In both cases, the high quality of graphene is obtained by a reduction of the sublimation rate of silicon atoms from the silicon carbide surface by introducing additional external silicon atoms to the atmosphere in the nearest vicinity of the silicon carbide surface. However, these methods differ in numerous important aspects.

Firstly, in the Patent Application No. US 20110223094 A1, the graphitisation process of the silicon carbide surface is carried out in a vacuum chamber ensuring a baseline pressure of the order of 1.3×10⁻⁴ Pa (see Fig. 1A in the cited document). Thus, the described method suffers from the same significant purity limitation as the method described in the Patent No. US 9150417 B2, in which the sublimation rate of silicon atoms is reduced by an application of buffer gases. The baseline pressure of the order of 1.3×10⁻³-1.3×10⁻⁴ Pa corresponds to an exposure of the surface to unknown impurities of the order of 1⁻¹⁰ L/s even before the beginning of annealing. It is a better value than that obtained while using buffer gases, however it corresponds still to a high degree of the sample contamination. During annealing at so high temperatures, the pressure in the chamber deteriorates by at least one order of magnitude, thus the exposure to impurities amounts to at least 10⁻¹⁰⁰ L/s.

On the other hand, the method according to the invention yields results different from the point of view of quality, thanks to application of a baseline pressure on the level of ultra-high vacuum, or approx. 1×10⁻⁸ Pa (an exposure of the order of 0.0001 L/s), as well as maintaining the pressure in the chamber during the annealing at a level better than 5×10⁻⁵ Pa (an exposure of the order of 0.5 L/s, or two orders of magnitude lower than in the method known from US 20110223094 A1).

Moreover, the method described in the Patent Application No. US 20110223094 A1 does not plan a precise control over the value of the stream (partial pressure) of silicon atoms in the direct vicinity of the sample, apart from increasing the distance between the crystals.

Meanwhile, the method according to the invention allows for precise controlling of the value of the stream of silicon atoms and its change depending on the annealing temperature and time for the silicon carbide crystal. Thank to precise control over the process parameters, the obtained results are significantly different than those obtained by the methods known earlier.

Also, the state of art does not provide the preliminary preparation of the silicon carbide surface.

On the other hand, in the preferred embodiment of the method according to the invention, a preparation of the starting surface of silicon carbide subjected to graphitisation is carried out by annealing it at temperatures of 100ºC-850ºC under ultra-high vacuum, followed by annealing it at a temperature of 900-1100ºC in a stream of silicon atoms, corresponding to a nominal rate of silicon growth of 0.5-2.5×10⁻¹⁰m/min, under ultra-high vacuum, and then cooling the crystal to room temperature. The preliminary preparation results in removal of impurities from the surface of silicon carbide before commencing graphitisation, during which the impurities could diffuse to the interior of the crystal, as well as form structural defects in the graphene layer and also, it results in formation of a high crystallographic order ((3×3) reconstruction of the surface) and smoothing of step edges. The presented results confirm that the preliminary preparation of the surface affects the quality and the structure of the graphene obtained in the graphitisation process advantageously.

Also, the known method excludes a direct control over temperature of the silicon carbide surface.

On the other hand, the method according to the invention executes such a control using an optical pyrometer directed onto the sample. A precise temperature control is very important for obtaining optimal and repeatable results.

The lack of a direct measurement of temperature on the surface in the method known from the state of art leads to a lack of repeatability of the results and a lower credibility of the results reported by the authors of the cited documents - all direct methods for temperature measurement such by thermocouples, or a pyrometer directed onto the rear surface of an annealed SiC crystal results in a very high uncertainty and possible temperature oscillations during the process, impairing the quality of the graphene being synthesised.

## Claims

1. A method for preparation of graphene on the surface of silicon carbide, **characterised in that** an SiC crystal with a crystallographic orientation of the surface (0001), is subjected to, consecutively:
a) a pressure below 1×10⁻⁷ Pa;
b) annealing at a temperature from 1300°C do 1800°C, under a pressure not higher than 5×10⁻⁵ Pa, in a stream of silicon atoms from an external sublimation source corresponding to a nominal silicon growth rate from 0.5×10⁻¹⁰ m/min to 10×10⁻¹ m/min.

2. The method according to claim 1, **characterised in that** the SiC crystal is subjected to a step of degassing by annealing at a temperature from 100°C to 850°C under a pressure not higher than 1×10⁻⁷ Pa, performed between the steps a) and b).

3. The method according to claim 1, **characterised in that** the SiC crystal is subjected to annealing at a temperature from 900°C to 1050°C in a stream of silicon atoms from an external sublimation source corresponding to a nominal silicon growth rate from 0.5×10⁻¹⁰ m/min to 2.5×10⁻¹⁰ m/min, performed between the steps a) and b).

4. The method according to claim 2, **characterised in that** the SiC crystal is subjected to annealing at a temperature from 900°C to 1050°C in a stream of silicon atoms from an external sublimation source corresponding to a nominal silicon growth rate from 0.5×10⁻¹⁰ m/min to 2.5×10⁻¹⁰ m/min, performed between the step of degassing and the step b).

## Patentansprüche

1. Verfahren zur Herstellung von Graphen auf der Oberfläche von Siliciumcarbid, **dadurch gekennzeichnet, dass** ein SiC-Kristall mit einer kristallographischen Orientierung der Oberfläche (0001), nacheinander den Folgenden unterzogen wird:
a) einem Druck unter 1×10⁻⁷Pa;
b) Glühen bei einer Temperatur von 1300°C bis 1800°C, unter einem Druck von nicht mehr als 5×10⁻⁵ Pa, in einem Strom von Siliciumatomen aus einer externen Sublimationsquelle entsprechend einer nominalen Siliciumwachstumsrate von 0,5×10⁻¹⁰ m/min bis 10×10⁻¹⁰ m/min.

2. Verfahren nach Anspruch 1, **dadurch gekennzeichnet, dass** der SiC-Kristall einem Schritt der Entgasung durch Glühen bei einerTemperatur von 100°C bis 850°C unter einem Druck von nicht mehr als 1×10⁻⁷ Pa unterzogen wird, der zwischen den Schritten a) und b) durchgeführt wird.

3. Verfahren nach Anspruch 1, **dadurch gekennzeichnet, dass** der SiC-Kristall einem Glühen bei einer Temperatur von 900°C bis 1050°C in einem Strom von Siliciumatomen aus einer externen Sublimationsquelle entsprechend einer nominalen Siliciumwachstumsrate von 0,5×10⁻¹⁰ m/min bis 2,5×10⁻¹⁰ m/min unterzogen wird, die zwischen den Schritten a) und b) durchgeführt wird.

4. Verfahren nach Anspruch 2, **dadurch gekennzeichnet, dass** der SiC-Kristall einem Glühen bei einer Temperatur von 900°C bis 1050°C in einem Strom von Siliciumatomen aus einer externen Sublimationsquelle entsprechend einer nominalen Siliciumwachstumsrate von 0,5×10⁻¹⁰ m/min bis 2,5×10⁻¹⁰ m/min unterzogen wird, die zwischen dem Schritt des Entgasens und dem Schritt b) durchgeführt wird.

## Revendications

1. Une méthode pour la préparation de graphène sur la surface de carbure de silicium, **caractérisée en ce qu'**un cristal de SiC avec une orientation cristallographique de la surface (0001) est soumis, consécutivement, à :
a) une pression inférieure à 1×10⁻⁷ Pa ;
b) un recuit à une température de 1300°C à 1800°C, sous une pression non supérieure à 5×10⁻⁵ Pa, dans un flux d'atomes de silicium provenant d'une source de sublimation externe correspondant à une vitesse de croissance nominale du silicium de 0,5×10⁻¹⁰ m/min à 10×10⁻¹⁰ m/min.

2. La méthode selon la revendication 1, **caractérisée en ce que** le cristal de SiC est soumis à une étape de dégazage par recuit à une température de 100°C à 850°C sous une pression non supérieure à 1×10⁻⁷ Pa, effectuée entre les étapes a) et b).

3. La méthode selon la revendication 1, **caractérisée en ce que** le cristal de SiC est soumis à un recuit à une température de 900°C à 1050°C dans un flux d'atomes de silicium provenant d'une source de sublimation externe correspondant à une vitesse de croissance nominale du silicium de 0,5×10¹⁰ m/min à 2,5×10⁻¹⁰m/min, effectué entre les étapes a) et b).

4. Procédé selon la revendication 2, **caractérisée en ce que** le cristal de SiC est soumis à un recuit à une température de 900°C à 1050°C dans un flux d'atomes de silicium provenant d'une source de sublimation externe correspondant à une vitesse de croissance nominale du silicium de 0,5×10⁻¹⁰ m/min à 2,5×10⁻¹⁰m/min, effectué entre l'étape de dégazage et l'étape b).
